# EUROPEAN PATENT SPECIFICATION

(11) **EP 0 627 871 B1**
(45) Date of publication and mention of the grant of the patent: **17.12.1997**
(21) Application number: 94201524.9
(22) Date of filing: 30.05.1994
(51) Int. Cl.: H05B 41/29, H02M 3/158

(54) **Electronic supply for igniting and operating a high-pressure discharge lamp**
Elektronisches Vorschaltgerät zum Zünden und Betreiben von Hochdruckgasentladungslampen
Alimentation électronique pour amorcer et alimenter des lampes à décharge à forte pression

(30) Priority: 01.06.1993 EP 93201549
(43) Date of publication of application: 07.12.1994
(73) Proprietor: PHILIPS ELECTRONICS N.V., 5621 BA Eindhoven (NL)
(72) Inventor: Hendrix, Machiel Antonius Martinus, NL-5656 AA Eindhoven (NL)
(74) Representative: Dusseldorp, Jan Charles

(56) References cited:
- EP-A- 0 257 403
- EP-A- 0 460 573
- EP-A- 0 507 398
- DE-A- 3 813 672

## Description

The invention relates to an electronic supply for igniting and operating a high-pressure discharge lamp, comprising first driven main switching means for generating a high-frequency current through inductive means, and switching means suitable for subsequent current supply through the inductive means when the first main switching means are in the non-conducting state, which electronic supply is provided with a transformerless level shifter and with a driver circuit with at least switch drive means for driving the first driven main switching means.

A circuit arrangement of the kind mentioned in the opening paragraph is known from EP-A-0507398. First switching means and switch drive means in the known supply are constructed as (MOS)FETs to reduce losses during operation. The level shifter is transformerless, which is an important and favourable feature. Although in itself a transformer constitutes an excellent electrical separation, the use of a transformer, especially in circuits for the supply and operation of high-pressure discharge lamps, has among its disadvantages a comparatively great bulk and a comparatively high weight, also in the case of a low power transfer, and a high degree of unsuitability for integration. The level shifter is further provided with self-induction means for fast switching of the main switching means while switching losses are reduced at the same time. The known supply, which is suitable for generating a high-frequency current with a frequency of approximately 20 kHz, is of practical use up to frequencies of approximately 50 kHz. At frequencies above 50 kHz, however, the inevitable losses are found to assume unacceptable proportions. These losses are formed to a major extent by dissipation of energy stored in parasitic capacitances of the switch drive means during periodic switching into conduction of the switch drive means.

The use of high frequencies to above 200 kHz, however, is desirable. On the one hand, the use of such high frequencies renders it possible to use small inductive means. On the other hand, the use of high frequencies is favourable for preventing instabilities in lamp operation caused by acoustic resonances. This is of major importance, particularly where high-pressure sodium lamps and metal halide lamps are concerned.

The invention has for its object to provide a measure by which an electronic supply is rendered suitable for operation at high frequencies to above 200 kHz.

A circuit arrangement according to the invention is for this purpose characterized in that the switching means suitable for subsequent current supply form part of second driven main switching means which serve for periodic commutation of current through the inductive means. Owing to the periodic commutation of the current through the inductive means, the circuit arrangement according to the invention has the advantage that switching of the first main switching means into the conducting state can take place at a moment at which voltage across the first main switching means is substantially zero. This renders possible a fast switching with very low losses. It is furthermore possible to realise the level shifter without separate self-induction means. Since it was found in practice that a suitable choice of the dimensions of the level shifter self-induction means is a critical item as regards a good operation of the circuit arrangement, the possibility of dispensing with these self-induction means is an advantage.

Given a comparatively small supply voltage of the order of 20-30 V, the use of a p-channel MOSFET as the first main switching means and an n-channel MOSFET as the second switching means renders it possible to realise an electronic supply without level shifter in which the p-channel MOSFET is switched into conduction periodically when the voltage across the p-channel MOSFET is substantially zero. Such a supply proposed in the literature is unsuitable for use as a supply for igniting and operating a high-pressure discharge lamp. High-pressure discharge lamps have powers which vary from approximately 30 W to 1000 W or more. The use of low voltages for such power levels leads to high current levels which in their turn strongly reduce the possibility of miniaturising especially the inductive means. High current levels are also disadvantageous because of the losses which occur, in particular the switching losses. A major, even essential disadvantage of the proposed circuit arrangement is the necessary use of a p-channel MOSFET. Owing to the substantially smaller mobility of holes in semiconductors compared with that of electrons, a p-channel version leads to higher internal losses which can only be counteracted through increasing the semiconductor surface area. This necessarily leads to a considerable cost increase for such a p-channel MOSFET.

In an advantageous embodiment of the electronic supply, the level shifter is provided with a switch which constitutes a current source during switching into the conducting state. This renders it possible in an advantageous manner to limit the discharge current of the main switching means to be switched off. This discharge current is mainly a result of the internal parasitic capacitances of the relevant main switching means. The discharge current causes switching-off losses owing to dissipation to internal resistances of the main switching means. A reduction of the discharge current thus leads to a reduction in the switching-off losses.

Preferably, delaying means are present in the electronic supply for driving the switch fully into conduction with a delay. The driving into full conduction causes the main switching means to be non-conducting after the limited discharge current of the main switching means to be switched off has been flowing during the delay time generated by the delaying means.

A further improvement is obtainable in that the switch, when in the fully conducting state, is connected to a voltage which is negative relative to that of the electronic supply. Any residual voltage at the control electrode of the relevant main switching means owing to voltage drops across diode means thus remains below the threshold voltage required for conduction of the relevant main switching means.

The invention is applicable to each of the three generally known types of electronic supplies, *i.e.* up-converter, down-converter and flyback converter.

The above and other aspects of an embodiment of an electronic supply according to the invention will now be explained in more detail with reference to a drawing, in which
- Fig. 1a, b, c is an equivalent diagram of an electronic supply according to the invention for three main supply types, and
- Fig. 2 shows the electronic supply of Fig. 1a in more detail.

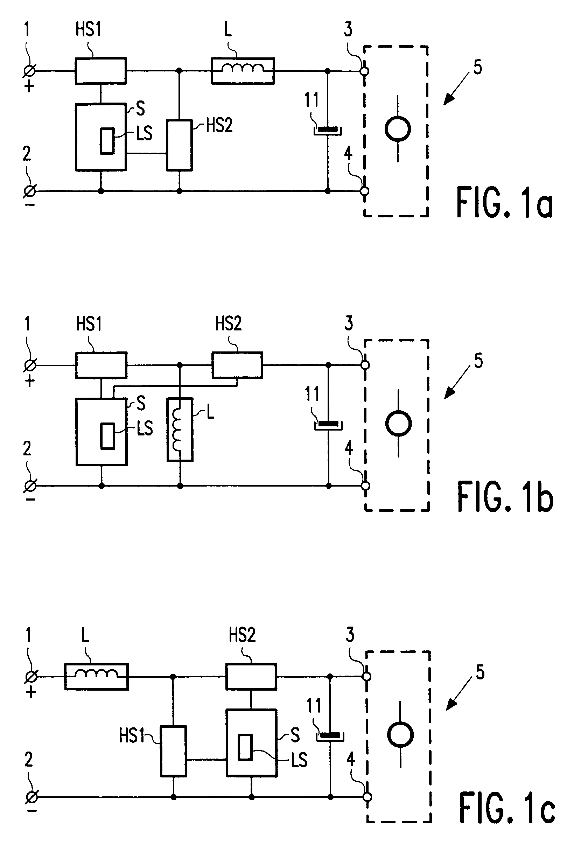

In Fig. 1a, b, c, corresponding parts are referenced correspondingly. 1 and 2 denote input terminals for connecting a DC voltage source, and 3, 4 are connection terminals for connecting a high-pressure discharge lamp 5 to be ignited and operated. The lamp may be included in a commutation circuit in this case. The connection terminals 3, 4 are also interconnected by capacitive means 11. The electronic supply comprises first driven main switching means HS 1 for generating a high-frequency current through inductive means L. HS 2 denotes second driven main switching means. The second driven main switching means HS 2 also comprise switching means which are suitable for subsequent current supply through the inductive means L when the first main switching means HS 1 are non-conducting. The electronic supply is provided with a transformerless level shifter LS and with a driver circuit S which comprises at least switch drive means for driving the main switching means HS 1 and HS 2. The level shifter, moreover, is free from self-induction means.

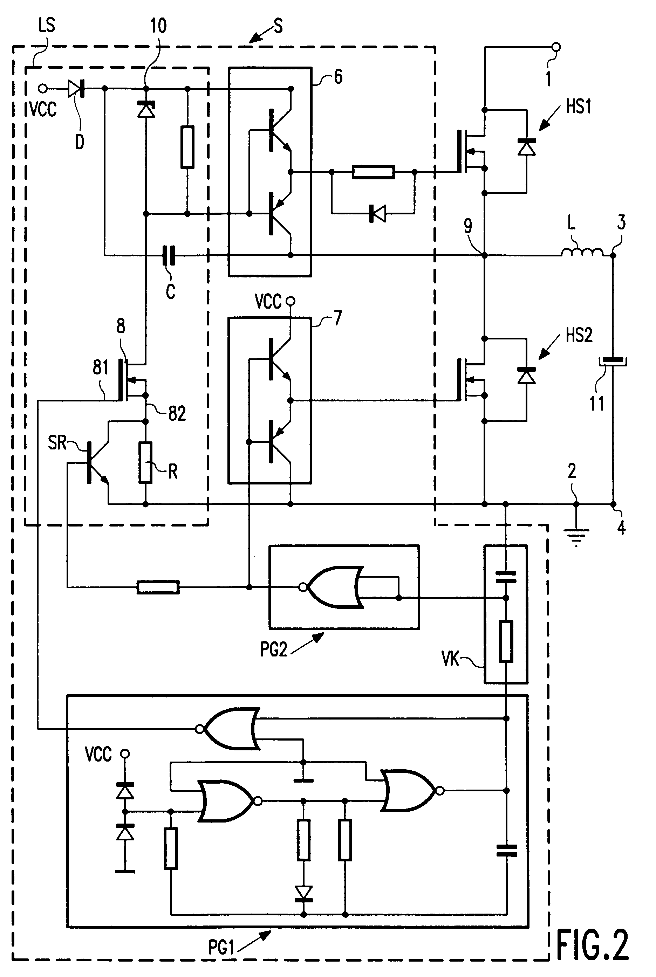

The electronic supply of Fig. 1a is shown in more detail in Fig. 2. The first and second main switching means HS 1 and HS 2 are constructed as MOSFETs and are accordingly provided each with an internal diode. The internal diode of MOSFET HS 2 serves for subsequent current supply through the inductive means L when the MOSFET HS 1 is in the non-conducting state.

S denotes a driver circuit which is provided with switch drive means 6, 7 for driving the first driven main switching means HS 1 and the second driven main switching means HS 2, respectively. A transformerless level shifter LS forms part of the driver circuit S and is free from self-induction means. The level shifter is provided with a switch 8, constructed as a FET, which is controlled by a pulse generator PG 1 at a gate 81. The switch 8 has a source branch 82 which includes a resistor R.

Resistor R is shunted by a switch SR. Switch SR is driven by a pulse generator PG 2 which in its turn is connected to an output of pulse generator PG 1 *via* a delay network VK.

The level shifter is supplied from an auxiliary voltage Vcc which is connected through a diode D on the one hand to switch 8 and on the other hand to a capacitor C. The capacitor C is connected at junction 9 to both the main switching means HS 1 and HS 2 and the inductive means L. With the switch 8 in the conducting state, and accordingly HS 1 in the non-conducting state, the capacitor C is charged by means of the auxiliary voltage Vcc.

When the switch 8 is rendered non-conducting owing to a signal from pulse generator PG 1, the first main switching means HS 1 will be rendered conducting by means of the auxiliary voltage Vcc and the switch drive means 6.

The moment the main switching means HS 1 are conducting, the voltage at point 10 follows the voltage at point 9 and thus that at the input terminal 1, rising to above the voltage Vcc. The main switching means HS 1 are then further supplied, and thus kept in the conducting state, from the capacitor C.

Then the switch 8 is rendered conducting again *via* the pulse generator PG 1. Together with the resistor R in the source branch 82, the switch 8 initially forms a current source. It is achieved by this that draining of charge from the first main switching means HS 1 takes place comparatively slowly, which is favourable for restricting switching losses.

With a delay supplied through the delay network VK, the pulse generator PG 2 supplies a pulse which is delayed relative to pulse generator PG 1, which pulse renders switch SR conducting, whereby resistor R is shunted. The switch 8 is driven fully into conduction by this, so that the first main switching means HS 1 are forced into the non-conducting state and kept that way.

The second main switching means HS 2 are rendered conducting by means of the same pulse generated by pulse generator PG 1 *via* control switches 7. Short-circuiting of the input terminals 1, 2 by the main switching means HS 1 and HS 2 is out of the question in this way. The risk of short-circuiting may be even further counteracted through the connection of resistor R and switch SR to a voltage which is negative compared with the electronic supply, more in particular to input terminal 2.

In the embodiment described, the two main switching means HS 1 and HS 2 are constructed as MOSFETs, *i.e.* with internal freewheel diodes. It is also possible to include separate, external freewheel diodes in the circuit arrangement.

The operation of the electronic supply is as follows.
In the conducting state, current flows through the first main switching means HS 1 to the inductive means L. Then the first main switching means HS 1 are rendered non-conducting, after which subsequent current supply takes place through the internal diode of the second main switching means. The current to the inductive means decreases during this, and commutation thereof takes place after a certain time. The capacitive means 11 serve as a current supply during this. Since the second main switching means HS 2 have been rendered conducting by the delay pulse originating from pulse generator PG 2 in the meantime, the commutated current can flow for some time. Subsequently, after a short time, the second main switching means HS 2 are rendered non-conducting. The current flowing through the inductive means L will subsequently charge the parasitic capacitance of the main switching means HS 1 until the voltage at point 9 has become equal to the voltage at point 1, after which the diode of the main switching means HS 1 will enter the conducting state. The comparatively small commutated current of the inductive means L now flows through the internal diode of the first main switching means HS 1 to input terminal 1, and will decrease further. In the period between the moment the internal diode of the first main switching means HS 1 becomes conducting and the moment the commutated current of the inductive means L becomes substantially zero, the first main switching means HS 1 are driven into the conducting state, after which the current will flow to the inductive means again.

In a practical realisation of the described embodiment of the electronic supply, the DC voltage at the input terminals 1, 2 was 380 V. The load at the connection terminals 3, 4 was formed by a 32 W metal halide lamp with a lamp voltage of 98 V. The generated high-frequency current had a frequency of 180 kHz. The power dissipated in the electronic supply was 1.3 W. The inductive means L had a value of 0.18 mH. The inductive means L were constructed as a pot core coil of the RM5 type with coil dimensions of 1 cm x 1 cm x 1 cm.

## Claims

1. An electronic supply for igniting and operating a high-pressure discharge lamp (5), comprising first driven main switching means (HS1) for generating a high-frequency current through inductive means (L), and switching means suitable for subsequent current supply through the inductive means (L) when the first main switching means (HS1) are in the non-conducting state, which electronic supply is provided with a transformerless level shifter (LS) and with a driver circuit (S) with at least switch drive means (6,7) for driving the first driven main switching means (HS1), characterized in that the switching means suitable for subsequent current supply form part of second driven main switching means (HS2) which serve for periodic commutation of current through the inductive means (L), and in that the level shifter (LS) is free from self-induction means.

2. An electronic supply as claimed in Claim 1, characterized in that the level shifter (LS) is provided with a switch (8) which constitutes a current source during switching into the conducting state.

3. An electronic supply as claimed in Claim 2, characterized in that delaying means are present for driving the switch fully into conduction with a delay.

4. An electronic supply as claimed in Claim 1, 2 or 3, characterized in that the switch (8), when in the fully conducting state, is connected to a voltage which is negative relative to that of the electronic supply.

## Patentansprüche

1. Elektronische Versorgung zum Zünden und Betreiben einer Hochdruck-Entladungslampe (5), mit ersten gesteuerten Hauptschaltmitteln (HS1) zum Erzeugen eines durch induktive Mittel (L) fließenden Hochfrequenzstroms und mit Schaltmitteln, die für eine anschließende Stromversorgung durch die induktiven Mittel (L) geeignet sind, wenn die ersten Hauptschaltmittel (HS1) sich im nichtleitenden Zustand befinden, wobei die elektronische Versorgung mit einem transformatorlosen Pegelschieber (LS) und mit einer Treiberschaltung (S) mit zumindest Schalteransteuerungmitteln (6, 7) zum Ansteuern der ersten gesteuerten Hauptschaltmittel (HS1) versehen ist, dadurch gekennzeichnet, daß die zur anschließenden Stromversorgung geeigneten Schaltmittel Teil zweiter gesteuerter Hauptschaltmittel (HS2) sind, die für eine periodische Umschaltung von durch die induktiven Mittel (L) fließendem Strom dienen, und daß der Pegelschieber (LS) von Selbstinduktionsmitteln frei ist.

2. Elektronische Versorgung nach Anspruch 1, dadurch gekennzeichnet, daß der Pegelschieber (LS) mit einem Schalter (T) versehen ist, der beim Schalten in den leitenden Zustand eine Stromquelle bildet.

3. Elektronische Versorgung nach Anspruch 2, dadurch gekennzeichnet, daß Verzögerungsmittel vorhanden sind, um den Schalter mit einer Verzögerung vollständig in den leitenden Zustand zu steuern.

4. Elektronische Versorgung nach Anspruch 1, 2 oder 3, dadurch gekennzeichnet, daß der Schalter (T), wenn er sich im vollständig leitenden Zustand befindet, an eine relativ zur Spannung der elektronischen Versorgung negative Spannung angeschlossen ist.

## Revendications

1. Alimentation électronique pour amorcer et pour faire fonctionner une lampe à décharge à haute pression (5), comportant des premiers moyens commutateurs principaux commandés (HS1) pour engendrer un courant haute fréquence à travers des moyens d'induction (L) et des moyens commutateurs convenables pour l'alimentation en courant ultérieure à travers les moyens d'induction (L) lorsque les premiers moyens commutateurs principaux (HS1) sont à l'état non conducteur, ladite alimentation électronique étant munie d'un levier de décalage de niveau (LS) sans transformateur et d'un circuit de commande (S) présentant au moins des moyens de commande de commutation (6, 7) pour commander les premiers moyens commutateurs principaux commandés (HS1), caractérisée en ce que les moyens commutateurs convenables pour l'alimentation en courant ultérieure font partie de deuxièmes moyens commutateurs principaux commandés (HS2) qui servent à réaliser une commutation périodique de courant à travers les moyens d'induction (L) et en ce que le levier de décalage de niveau (LS) est exempt de moyens d'auto-induction.

2. Alimentation électronique selon la revendication 1, caractérisée en ce que le levier de décalage de niveau (LS) est muni d'un commutateur (8) qui constitue une source de courant pendant la commutation à l'état conducteur.

3. Alimentation électronique selon la revendication 2, caractérisée en ce que des moyens retardateurs sont présents pour mettre le commutateur complètement en état conducteur avec un retard.

4. Alimentation électronique selon la revendication 1, 2 ou 3, caractérisée en ce que le commutateur (8), lorsqu'il est complètement à l'état conducteur, est connecté à une tension qui est négative par rapport à celle de l'alimentation électronique.
